# EUROPÄISCHE PATENTSCHRIFT

(11) **EP 0 824 789 B1**
(45) Veröffentlichungstag und Bekanntmachung des Hinweises auf die Patenterteilung: **08.08.2001**
(21) Anmeldenummer: 96914851.9
(22) Anmeldetag: 07.05.1996
(51) Int. Cl.: H03K 5/19, H03K 5/153, G11C 7/00

(54) **VORRICHTUNG ZUR TAKTERZEUGUNG FÜR CMOS-SCHALTUNGEN MIT DYNAMISCHEN REGISTERN**
CLOCK GENERATOR FOR CMOS CIRCUITS WITH DYNAMIC REGISTERS
DISPOSITIF GENERATEUR D'IMPULSIONS D'HORLOGE POUR CIRCUITS CMOS A REGISTRES DYNAMIQUES

(30) Priorität: 11.05.1995 DE 19517354
(43) Veröffentlichungstag der Anmeldung: 25.02.1998
(73) Patentinhaber: Infineon Technologies AG, 81669 München (DE)
(72) Erfinder: NOLL, Tobias, D-52072 Aachen (DE); MEIER, Stefan, D-81739 München (DE); SCHÖBINGER, Matthias, D-81825 München (DE); DE MAN, Erik, D-81739 München (DE)
(74) Vertreter: Zedlitz, Peter, Dipl.-Inf.
(86) Internationale Anmeldenummer: DE9600794
(87) Internationale Veröffentlichungsnummer: WO9636113

(56) Entgegenhaltungen:
- EP-A- 0 428 869
- DE-C- 4 321 315
- US-A- 4 476 401
- US-A- 4 622 481
- US-A- 4 653 054
- US-A- 4 920 282
- US-A- 5 175 751
- PATENT ABSTRACTS OF JAPAN, Band 11, Nr. 165 (E-510) , 27. Mai 1987 & JP 61 296821 A

## Beschreibung

In digitalen integrierten Schaltungen für hohe Durchsatzraten wird häufig das sogenannte Pipelining-Prinzip angewandt, um die erforderliche Verarbeitungsgeschwindigkeit zu erreichen. Hierzu werden Pipelineregister als Zwischenspeicher im Datenpfad eingefügt. Diese Pipelineregister können effizient als über den Datenpfad verteilte dynamische Halteglieder (latches) realisiert werden. Ein derartiges Halteglied besteht aus einem getakteten Schalter und einer Speicherkapazität, wobei als Speicherkapazität die parasitäre Eingangskapazität eines jeweils nachfolgenden Logikblocks genutzt wird. Geeignete Taktsignale steuern dabei die Halteglieder bzw. die Schalter und damit den zeitlichen Ablauf des Datenflusses im Datenpfad. Die Halteglieder arbeiten dabei nach dem Master/Slave-Prinzip, wobei die sogenannten Master-Latches etwa eine halbe Taktperiode durchgeschaltet und die sogenannten Slave-Latches gesperrt und während der nächsten halben Taktperiode die Slave-Latches durchgeschaltet und die Master-Latches gesperrt sind. Beim Sperren der Latches bleibt der logische Zustand am Eingang des nachfolgenden Logikblocks dynamisch in Form einer elektrischen Ladung auf der parasitären Eingangskapazität gespeichert. Die Zeit, über die diese Ladung gespeichert bleibt, ist aufgrund von Leckströmen typischerweise auf etwa eine Millisekunde beschränkt. Dies ist im Normalbetrieb, wenn die Taktsignale eine Schaltfrequenz in der Größenordnung von mehreren Megahertz haben, ohne Bedeutung.

Fehlt nun aus irgend einem Grund das Taktsignal, zum Beispiel wenn der Generator im System ausfällt oder beim Einschalten des Systems erst verspätet anläuft, so sind entweder alle Schalter der Master-Latches oder alle Schalter der Slave-Latches gesperrt und bleiben in diesem Zustand. Der logische Zustand auf diesem Speicherknoten ist z. B. spätestens nach etwa einer Millisekunde undefiniert. Diese Knoten liegen auf einem Potential, das nur durch parasitäre Widerstände und Leckströme bestimmt wird. Die Spannung an diesem Knoten wird bei einer typischen Dimensionierung der Transistoren in den Latches zwischen 1 Volt und 4 Volt liegen. Weil die Eingänge der nachfolgenden CMOS-Gatter in diesem Fall nicht auf einem definierten CMOS-Pegel, von beispielsweise 5 und 0 Volt liegen, besteht die Möglichkeit daß in diesen Gattern ein Querstrom fließt. Obwohl der Querstrom in einem einzigen CMOS-Gatter im Mikroampere-Bereich liegt, kann die Anzahl der undefinierten Knoten in einer Schaltung mit einem hohen Grad an Pipelining sehr groß werden, so daß die gesamte Stromaufnahme beim Wegfall des Taktsignales im Ampere-Bereich liegen kann.

Aus der japanischen Patentanmeldung JP-A-61 296 821 bzw. aus PATENT ABSTRACTS OF JAPAN, Band 11, Nr. 165 (E-510), 27-05-1987 ist eine Vorrichtung bekannt, mit deren Hilfe der Leistungsverbrauch in einer Schaltung dadurch verringert wird, daß Schalt-MOS-Transistoren im eingeschalteten Zustand bleiben, wenn ein Eingangstakt ausfällt.

Die der Erfindung zugrundeliegende Aufgabe besteht nun darin eine Vorrichtung zur Takterzeugung für CMOS-Schaltungen mit dynamischen Registern anzugeben, bei der im Falle von zu niedrigen Taktraten oder im Falle des vollständigen Fehlens eines Taktsignales die gesamte Stromaufnahme im Vergleich zum Normalbetrieb mit anliegendem vorschriftsmäßigem Taktsignal praktisch nicht erhöht ist. Dies wird durch die im Patentanspruch 1 oder 2 angegebenen Merkmale erfindungsgemäß gelöst.

Vorteilhaft ist hierbei, daß die CMOS-Schaltung nicht in unzulässiger Weise aufgeheizt wird oder eine Überlastung einer mit der CMOS-Schaltung verbundenen Spannungsversorgung auftritt. Ein weiterer Vorteil besteht darin, daß in der Fertigungskontrolle eine Überprüfung der Leckströme wesentlich störungsfreier durchgeführt werden kann.

Die Erfindung ist nachfolgend anhand der Zeichnung näher erläutert. Dabei zeigt
- Figur 1: ein Schaltbild der erfindungsgemäßen Vorrichtung zur Takterzeugung zusammen mit zwei Pipelinestufen,
- Figur 2: eine vorteilhafte Ausführungsform der Logikschaltungen von Figur 1,
- Figur 3: eine vorteilhafte Ausgestaltung der Taktüberwachungseinheit von Figur 1 und
- Figur 4: eine weitere vorteilhafte Ausgestaltung der Taktüberwachungseinheit von Figur 1.

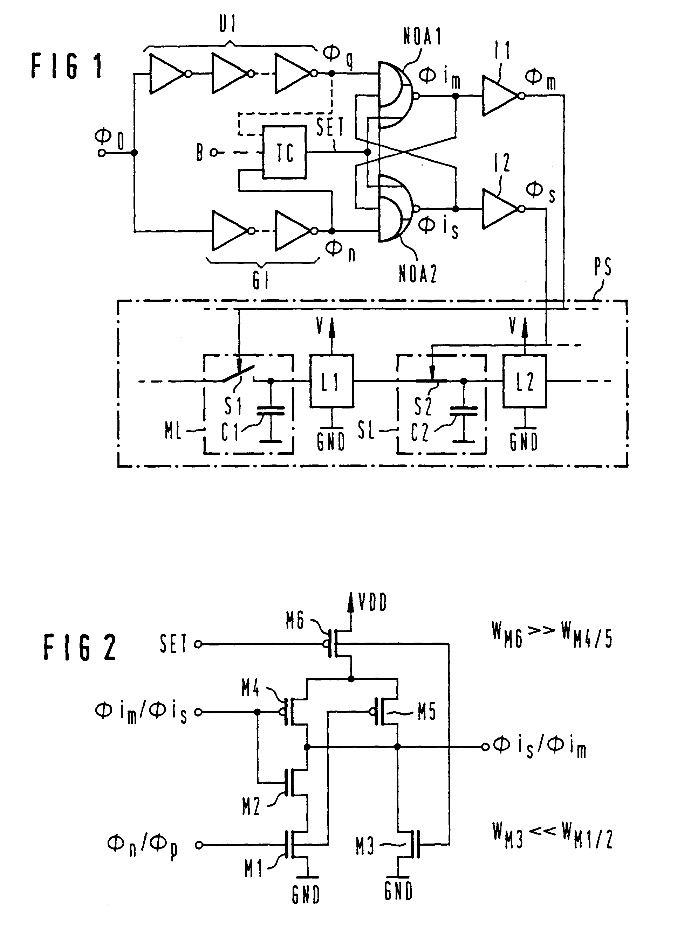

In Figur 1 ist eine erfindungsgemäße Vorrichtung zur Takterzeugung zusammen mit einer Pipeline-Schaltung PS dargestellt, wobei die Schaltung PS einen Logikblock L1 mit vorgeschaltetem Master-Latch ML sowie einen zweiten Logikblock L2 aufweist, der über ein Slave-Latch SL mit dem ersten Logikblock L1 verbunden ist. Das Master-Latch ML besteht dabei aus einem Schalter S1, der durch einen Master-Takt **Φ**ₘ angesteuert wird, und einer parasitären Eingangskapazität C1 des Logikblocks L1 als Speicherkapazität. Das Slave-Latch SL besteht aus einem Schalter S2, der durch ein Slave-Taktsignal Φₛ angesteuert wird, und einer parasitären Eingangskapazität C2 des Logikblocks L2. Die Logikblöcke L1 und L2 sind mit einer Versorgungsspannung VDD und Bezugspotential GND verbunden.

Der Master-Takt **Φ**ₘ und der Slave-Takt Φₛ wird in einer erfindungsgemäßen Vorrichtung zur Takterzeugung gebildet, die z. B. aus einer Reihe von Invertern UI, GI, I1 und I2, zwei Logikschaltungen NOA1 und NOA2 sowie einer Taktüberwachungsschaltung TC besteht.

Ein Taktsignal **Φ**q wird, beispielsweise mit Hilfe einer ungerade Anzahl von Invertern UI, durch Invertieren des Eingangstaktsignals Φ₀ und ein Taktsignal Φₙ wird, beispielsweise direkt oder mit Hilfe einer geraden Zahl von Invertern GI, ohne Invertieren aus dem Eingangstaktsignals **Φ**₀ gebildet. Aus den beiden Taktsignalen **Φ**_{q} und **Φ**ₙ wird mit Hilfe der Taktüberwachungseinrichtung TC ein Setzsignal SET gebildet, wobei eine weitere Ausführungsform der Taktüberwachungseinheit TC, die lediglich das Taktsignal **Φ**ₙ und kein Taktsignal Φ_{q} benötigt, in Fig.1 gestrichelt angedeutet ist.

Schließlich ist in Figur 1 noch eine Ausführungsform gestrichelt angedeutet, bei der in der Taktüberwachungseinheit TC das Setzsignal SET zusätzlich auch abhängig von einem externen Blockausschaltsignal B so gesetzt werden kann, daß die Schalter S1 und S2 der Pipeline-Schaltung PS geschlossen sind. Diese Ausführungsform ist für den Fall gedacht, daß mehrere Blöcke mit jeweils einer erfindungsgemäßen Vorrichtung zur Takterzeugung und jeweils einer zugehörigen Pipeline-Schaltung vorliegen.

Die Logikschaltungen NOA1 und NOA2 bestehen jeweils aus einem Zweifach-UND-Gatter, dessen Ausgang über ein Zweifach-NOR-Gatter mit einem dritten Eingang zum Ausgangssignal der Logikschaltung verknüpft sind. Ein Eingang des UND-Gatters erhält dabei das Taktsignal **Φ**_{q} und der andere Eingang des UND-Gatters ein invertiertes Slave-Taktsignal **Φ**iₛ am Ausgang der Logikschaltung NOA2 und der NOR-Eingang der Logikschaltung NOA1 ist mit dem Ausgang der Taktüberwachungseinheit verbunden und erhält das Signal SET. Entsprechend erhält ein erster Eingang der UND-Verknüpfung der Logikschaltung NOA2 das Taktsignal **Φ** ₙ und der zweite Eingang des UND-Gatters erhält das rückgekoppelte Taktsignal Φiₘ und der NOR-Eingang der Logikschaltung NOA2 erhält das Setzsignal SET. In diesem Beispiel wird das Master-Taktsignal Φₘ durch einen Inverter I1 aus dem invertierten Master-Taktsignal Φiₘ und das Slave-Taktsignal **Φ**ₛ durch den Inverter I2 aus dem invertierten Slave-Taktsignal Φiₛ gebildet. Auf die Inverter I1 und I2 kann gegebenenfalls je nach Art der Schalter S1 und S2 auch verzichtet werden.

Im Normalbetrieb, also bei vorschriftsmäßigem Eingangstaktsignal Φ₀ verhindert die Vorrichtung zur Takterzeugung, daß die Schalter S1 und S2 gleichzeitig geschlosen sind. Im Falle eines Eingangstaktsignals **Φ**₀, das eine Taktrate aufweist, die kleiner ist als eine vorgegebene minimale Taktrate, erzeugt die Taktüberwachungseinrichtung TC ein Signal SET = logisch Eins, das über die beiden Logikschaltungen NOA1 und NOA2 zusammen mit den Invertern I1 und I2 ein Master-Taktsignal **Φ**ₘ = logisch Eins und ein Slave-Taktsignal Φₛ = logisch Eins bewirkt, wodurch die Schalter S1 und S2 geschlossen werden und an den Eingängen der Logikblöcke L1 und L2 definierte Potentialverhältnisse eingestellt werden und somit auch in diesem Fall Querströme in den Logikblöcken L1 und L2 verhindert werden.

Figur 2 zeigt eine vorteilhafte Ausgestaltung der Logikschaltung NOA1 und/oder NOA2, die aus drei n-Kanal-MOS-Feldeffekttransistoren M1 ... M3 und drei p-Kanal-MOS-Feldeffekttransistoren M4 ... M6 besteht. Die Feldeffekttransistoren M1, M2, M4 und M6 sind dabei in Reihe geschaltet und die Reihenschaltung liegt zwischen Bezugspotential und einer Versorgungsspannung VDD. Ferner sind die Feldeffekttransistoren M3, M5 und M6 in Reihe geschaltet und diese Reihenschaltung liegt ebenfalls zwischen Bezugspotential GND und der Versorgungsspannung VDD. Die Gateanschlüsse der Transistoren M2 und M4 sind im Falle der Logikschaltung NOA2 mit dem Taktsignal Φiₘ und im Falle der Logikschaltung NOA1 mit dem Taktsignal Φiₛ versorgt. Die Feldeffekttransistoren M1 und M5 sind im Falle der Logikschaltung NOA2 mit dem Taktsignal Φₙ und im Falle der Logikschaltung NOA1 mit dem Taktsignal Φₚ versorgt. Ein Verbindungsknoten zwischen dem Feldeffekttransistor M2 und dem Feldeffekttransistor M4 ist mit einem Verbindungsknoten zwischen den Feldeffekttransistoren M3 und M5 verbunden und führt im Falle der Logikschaltung NOA2 das Taktsignal Φiₛ und im Falle der Logikschaltung NOA1 das Taktsignal **Φ**iₘ. Die Gateanschlüsse der Feldeffekttransistoren M6 und M3 sind mit dem Setzsignal SET versorgt. Der Feldeffekttransistor M6 ist im Normalbetrieb durchgeschaltet und seine Transistorweite W_{M6} ist vorzugsweise mindestens eine Größenordnung größer zu dimensionieren als die Weiten W_{M4/5} der Feldeffekttransistoren M4 und M5 damit der Kanalwiderstand des Transistors M6 klein im Vergleich zu den durchgeschalteten Transistoren M4 und M5 ist. Ferner ist vorzugsweise die Weite W_{M3} mindestens eine Größenordnung kleiner zu wählen als die Weiten W_{M1/2} der Transistoren M1 und M2, damit die parasitäre Diffusionskapazität des Feldeffekttransistors M3 klein ist im Vergleich zur gesamten Kapazität die schon am Ausgang der jeweiligen Logikschaltung vorhanden ist.

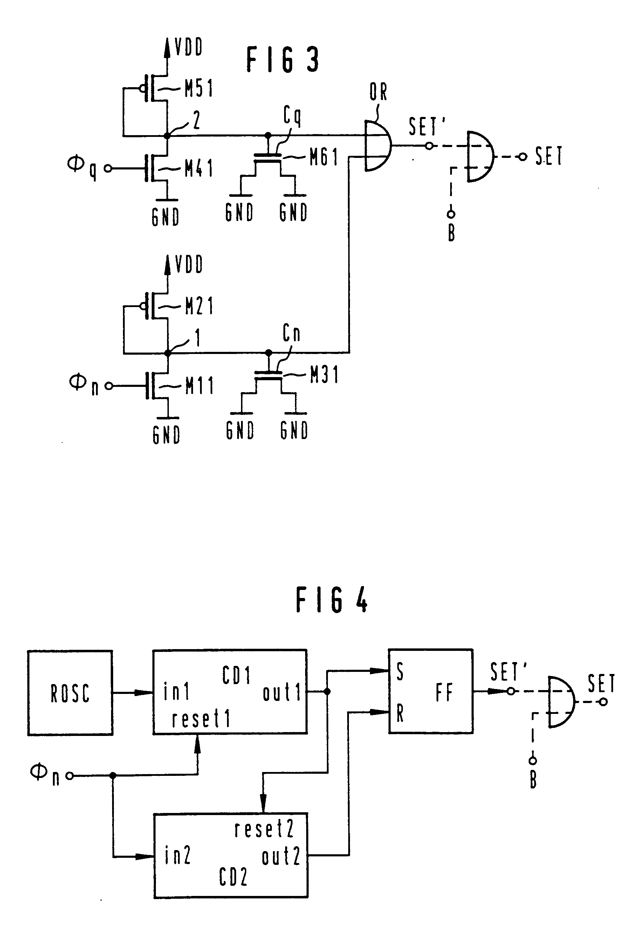

In Figur 3 ist eine Ausführungsform der Taktüberwachungsschaltung TC dargestellt, die besonders wenig Chipfläche benötigt. Die Taktüberwachungseinheit TC enthält hierbei mindestens die n-Kanal-Transistoren M11 und M41 und die p-Kanal-MOS-Feldeffekttransistoren M21 und M51, die Kapazitäten C_{q} und Cₙ sowie eine ODER-Schaltung OR. Die Kapazitäten C_{q} und Cn sind vorteilhafterweise durch weitere n-Kanal-MOS-Feldeffekttransistoren M31 und M61 realisierbar, wobei der Gateanschluß dieser Transistoren ein Anschluß der jeweiligen Kapazität und die jeweils auf Bezugspotential liegenden Source- und Drainanschlüsse den weiteren Anschluß der jeweiligen Kapazität darstellen. Die Feldeffekttransistoren M11 und M21 sind in Reihe geschaltet und die Reihenschaltung ist mit Bezugspotential GND und einer Versorgungsspannung VDD verbunden. Entsprechend sind die Transistoren M41 und M51 in Reihe geschaltet und die Reihenschaltung ist mit Bezugspotential GND und der Versorgungsspannung VDD verbunden. Dem Gateanschluß des Transistors M11 wird das Taktsignal **Φ**ₙ und dem Gateanschluß des Transistor M41 wird das Taktsignal **Φ**_{q} zugeführt. Der Verbindungsknoten 1 zwischen den beiden Transistoren M11 und M21 ist auf den Gateanschluß des Transistors M21 geführt, und mit einem Eingang der ODER-Schaltung OR verbunden wobei die Kapazität Cn zwischen diesem Eingang und Bezugspotential wirksam ist. Der Verbindungsknoten 2 zwischen den Transistoren M41 und M51 ist auf den Gateanschluß des Transistors M51 geführt und mit einem weiteren Eingang der ODER-Schaltung OR verbunden, wobei die Kapazität C_{q} zwischen dem weiteren Eingang und Bezugspotential wirksam ist. Am Ausgang der ODER-Schaltung ist ein Setzsignal SET' abgreifbar, das je nach Ausführungsform entweder direkt oder mit dem Blockabschaltsignal B ODER-vernüpft das Setzsignal SET bildet.

Bei laufendem Takt **Φ**ₒ werden die Taktsignal Φₙ und Φ_{q} ebenfalls hin und her geschaltet und entladen in der halben Taktphase, in der sie logisch Eins sind, die Gatekapazität der Transistoren M31 und M61. In der halben Taktphase, in der die Taktsignale **Φ**ₙ und **Φ**_{q} logisch Null sind, werden die Kapazitäten Cₙ bzw. C_{q} über die Pull-up-Transistoren M21 bzw. M51 aufgeladen. Die Transistoren M2 und M3 bzw. die Transistoren M5 und M6 bilden jeweils ein RC-Glied, wobei die Zeitkonstanten der RC-Glieder die minimal mögliche Taktfrequenz festlegt, bei der die Schaltung sich noch im Normalbetrieb befindet. Diese Zeitkonstante sollte im Bereich einiger Mikrosekunden liegen. Die Transistoren M11 und M4 müssen eine größere Weite als die Transistoren M21 bzw. M51 haben, um die Kapazitäten Cₙ bzw. C_{q}, die in der ersten Hälfte der Taktperiode über die Transistoren M21 bzw. M51 aufgeladen wurden, sicher entladen zu können. Bei fehlendem Taktsignal hat entweder das Taktsignal Φₙ oder **Φ**_{q} permanent den logischen Wert Null, so daß entweder das Gate des Transistors M31 oder das Gate des Transistors M61 nicht mehr entladen werden kann. Die Kapazitäten Cₙ oder C_{q} werden aufgeladen und nach einer Zeitverzögerung, die durch die besagten Zeitkonstanten bestimmt ist, nimmt der Setzausgang den logischen Wert Eins an.

In Figur 4 ist eine alternative Ausführungsform der Taktüberwachungseinheit TC in Form einer digitalen Schaltung gezeigt, die einen Ringoszillator ROSC, zwei Zähler/Dekodier-Einheiten CD1 und CD2 und ein RS-Flip-Flop FF aufweist. Der Ausgang des Ringoszillators ROSC ist mit einem Eingang in1 der Einheit CD1 verbunden. Einem Rücksetzeingang resetl der Einheit CD1 und einem Eingang in2 der Einheit CD2 wird das Taktsignal **Φ**ₙ zugeführt. Der Ausgang out1 der Einheit CD1 ist mit dem Setzeingang S des Flip-Flops FF und einem Rücksetzeingang reset2 der Einheit CD2 verbunden. Der Ausgang out2 der Einheit CD2 ist mit dem Rücksetzeingang R des Flip-Flops FF verbunden und der Ausgang dieses Flip-Flops liefert das Setzsignal SET', das je nach Ausführungsform entweder direkt oder mit dem Blockabschaltsignal B ODER-vernüpft das Setzsignal SET bildet.

Der Ringoszillator ROC ist freilaufend und erzeugt ein Signal, das in der Zähler/Dekodier-Einheit CD1 so heruntergeteilt und dekodiert wird, daß nach jeweils n Eingangsimpulsen ein Ausgangsimpuls erzeugt wird. Der Rücksetzeingang reset1 ist flankengetriggert und mit dem Taktsignal Φₙ beschaltet, wodurch im Normalbetrieb der Zähler jeweils rückgesetzt wird bevor der Zählerstand n erreicht ist. Falls kein Taktsignal, oder nur ein Signal in einer zu niedrigen Taktrate vorhanden ist, wird der Zählerstand n erreicht und das Ausgangssignal des Zählers setzt das RS-Flip-Flop. Dieses Flip-Flop wird über seinen Rücksetzeingang R von der Zähler/Dekodier-Einheit CD2 zurückgesetzt, wenn mehrere Taktimpulse gezählt wurden, ohne daß die Einheit CD1 bis zum Zustand n zählen konnte. In der Einheit CD1 wird das Verhältnis zwischen der Taktfrequenz des freilaufenden Ringoszillators ROSC und der minimalen Taktrate, mit der der Chip betrieben werden soll, festgelegt. In der Einheit CD2 wird festgelegt wieviele Taktimpulse, bei einer Taktrate die größer oder gleich der minimalen Taktfrequenz ist, gezählt werden sollen, bevor das Setzsignal SET wieder ausgeschaltet wird. Die Vorteile gegenüber der Ausführungsform von Figur 3 bestehen darin, daß sich das Verhältnis zwischen minimaler Taktrate und der Taktrate des Ringoszillators durch die Anzahl der Zählerstufen in der Einheit CD1 frei festgelegt werden kann bzw. gegebenenfalls sogar programmierbar ausgestaltet werden kann. Darüber hinaus kann diese Ausgestaltungsform in einem Standardzellensystem wesentlich einfacher verwirklicht werden als die Ausführungsform von Figur 3.

## Patentansprüche

1. Vorrichtung zur Takterzeugung für eine Pipeline-Schaltung (PS) mit dynamischen Registern in Form von Logikblöcken (L1, L2) vorgeschalteten dynamischen Master- und Slave-Latches, die aus jeweils einem Schalter (S1) und einer parasitären Kapazität (C1) des jeweiligen Logikblocks bestehen,
- bei der eine Taktüberwachungseinrichtung (TC) vorgesehen ist, die ermittelt, ob eine vorgegebene minimale Taktrate eines Eingangstaktsignals (**Φ**₀) unterschritten wird oder nicht,
- bei der Mittel (UI,GI, NOA1,NOA2) vorgesehen sind, die aus einem Eingangstaktsignal (**Φ**₀) ein Master-Taktsignal (**Φ**ₘ) und ein Slave-Taktsignal (**Φ**ₛ) bilden, welche so geartet sind, daß sowohl alle Schalter (S1) der dynamischen Master-Latches (ML) als auch alle Schalter (S2) der dynamischen Slave-Latches (SL) geschlossen sind, sofern die minimale Taktrate unterschritten wird, und sonst höchstens entweder alle Schalter (S1) der dynamischen Master-Latches (ML) oder alle Schalter (S2) der dynamischen Slave-Latches (SL) geschlossen sind,
- bei der aus dem Eingangstaktsignal (**Φ**₀) ein erstes Taktsignal (Φ_{q}) und ein dazu inverses zweites Taktsignal (Φₙ) gebildet sind,
- bei der in einer ersten Logikschaltung (NOA1) das erste Taktsignal mit dem invertierten Slave-Taktsignal (**Φ**iₛ) UND-verknüpft und anschließend mit einem Setzsignal (SET) zum invertierten Master-Taktsignal (**Φ**iₘ) NOR-verknüpft sind,
- bei der in einer zweiten Logikschaltung (NOA2) das zweite Taktsignal mit dem invertierten Master-Taktsignal UND-verknüpft und anschließend mit dem Setzsignal (SET) zum invertierten Slave-Taktsignal NOR-verknüpft sind und
- bei der die Taktüberwachungseinrichtung (TC) derart vorgesehen ist, daß sie das Setzsignal (SET) gleich logisch Eins setzt, wenn eine minimale Taktrate des Eingangstaktsignals unterschritten wird, und
- bei der die Taktüberwachungseinrichtung (TC) mit einem weiteren ersten und zweiten n-Kanal-MOS-Feldeffekttransistor (M11, M41), einem weiteren ersten und zweiten p-Kanal-MOS-Feldeffekttransistor (M21, M51), einer ersten Kapazität (C_{q}) und einer zweiten Kapazität (Cₙ) sowie einer ODER-Schaltung (OR) aufgebaut ist,
- wobei der weitere erste n-Kanal-MOS-Feldeffekttransistor (M11) und der weitere erste p-Kanal-MOS-Feldeffekttransistor (M21) über einen ersten Verbindungspunkt (1) in Reihe geschaltet und die Reihenschaltung mit Bezugspotential (GND) und einer Versorgungsspannung (VDD) verbunden ist,
- wobei der weitere zweite n-Kanal-MOS-Feldeffekttransistor (M41) und der weitere zweite p-Kanal-MOS-Feldeffekttransistor (M51) über einen zweiten Verbindungspunkt (2) in Reihe geschaltet und die Reihenschaltung mit Bezugspotential (GND) und einer Versorgungsspannung (VDD) verbunden ist,
- wobei der erste Verbindungspunkt (1) direkt mit dem Gateanschluß des ersten p-Kanal-MOS-Feldeffekttransistors (M21), direkt mit einem ersten Eingang der ODER-Schaltung und über die erste Kapazität mit Bezugspotential (GND) verbunden ist,
- wobei der zweite Verbindungspunkt (2) direkt mit dem Gateanschluß des zweiten p-Kanal-MOS-Feldeffekttransistors (M51), direkt mit einem zweiten Eingang der ODER-Schaltung und über die zweite Kapazität mit Bezugspotential (GND) verbunden ist und
- wobei am Gateanschluß des weiteren ersten n-Kanal-MOS-Feldeffekttransistors (M11) das erste Taktsignal (**Φ**ₙ),am Gateanschluß des weiteren zweiten n-Kanal-MOS-Feldeffekttransistors (M21) das zweite Taktsignal (**Φ**ₚ) und am Ausgang der ODER-Schaltung das Setzsignal (SET) anliegt.

2. Vorrichtung zur Takterzeugung für eine Pipeline-Schaltung (PS) mit dynamischen Registern in Form von Logikblöcken (L1, L2) vorgeschalteten dynamischen Master- und Slave-Latches, die aus jeweils einem Schalter (S1) und einer parasitären Kapazität (C1) des jeweiligen Logikblocks bestehen,
- bei der eine Taktüberwachungseinrichtung (TC) vorgesehen ist, die ermittelt, ob eine vorgegebene minimale Taktrate eines Eingangstaktsignals (Φ₀) unterschritten wird oder nicht,
- bei der Mittel (UI,GI, NOA1,NOA2) vorgesehen sind, die aus einem Eingangstaktsignal (**Φ**₀) ein Master-Taktsignal (**Φ**ₘ) und ein Slave-Taktsignal (**Φ**ₛ) bilden, welche so geartet sind, daß sowohl alle Schalter (S1) der dynamischen Master-Latches (ML) als auch alle Schalter (S2) der dynamischen Slave-Latches (SL) geschlossen sind, sofern die minimale Taktrate unterschritten wird, und sonst höchstens entweder alle Schalter (S1) der dynamischen Master-Latches (ML) oder alle Schalter (S2) der dynamischen Slave-Latches (SL) geschlossen sind,
- bei der aus dem Eingangstaktsignal (Φ₀) ein erstes Taktsignal (Φ_{q}) und ein dazu inverses zweites Taktsignal (**Φ**ₙ) gebildet sind,
- bei der in einer ersten Logikschaltung (NOA1) das erste Taktsignal mit dem invertierten Slave-Taktsignal (Φiₛ) UND-verknüpft und anschließend mit einem Setzsignal (SET) zum invertierten Master-Taktsignal (**Φ**iₘ) NOR-verknüpft sind,
- bei der in einer zweiten Logikschaltung (NOA2) das zweite Taktsignal mit dem invertierten Master-Taktsignal UND-verknüpft und anschließend mit dem Setzsignal (SET) zum invertierten Slave-Taktsignal NOR-verknüpft sind und
- bei der die Taktüberwachungseinrichtung (TC) derart vorgesehen ist, daß sie das Setzsignal (SET) gleich logisch Eins setzt, wenn eine minimale Taktrate des Eingangstaktsignals unterschritten wird, und
- bei der die Taktüberwachungseinrichtung (TC) einen Ringoszillator (ROSC), eine erste Zähler/Dekoder-Einheit (CD1), eine zweite Zähler/Dekoder-Einheit (CD2) und ein FlipFlop (FF) aufweist ,
- wobei ein Zählereingang (inl) der ersten Zähler/Dekodier-Einheit (CD1) mit einem Ausgang des Ringoszillators (ROSC), ein Rücksetzeingang (resetl) der ersten Zählers/Dekodier-Einheit mit einer Leitung für das erste Taktsignal (Φₙ) und ein Ausgang (outl) der ersten Zähler/Dekodier-Einheit mit einem Setzeingang (S) des RS-FlipFlops verbunden sind,
- wobei in der ersten Zähler/Dekodier-Einheit das Verhältnis der Taktrate des Ringoszillators (ROSC) zur minimalen Taktrate des Eingangstaktsignals festgelegt ist,
- wobei ein Zählereingang (in2) der zweiten Zähler/Dekodier-Einheit (CD2) mit der Leitung für das erste Taktsignal (**Φ** ₙ), ein Rücksetzeingang (reset2) der zweiten Zähler/Dekodier-Einheit mit dem Ausgang (outl) der ersten Zähler/Dekodier-Einheit und ein Ausgang (out2) der zweiten Zähler/Dekodier-Einheit mit einem Rücksetzeingang (R) des RS-FlipFlops verbunden sind,
- wobei in der zweiten Zähler/Dekodier-Einheit festgelegt ist, wieviele Taktimpulse bei einer Taktrate, die größer oder gleich der minimalen Taktrate des Eingangstaktsignals ist, gezählt werden, bevor das FlipFlop (FF) rückgesetzt wird und
- wobei am Ausgang des FlipFlops (FF) das Setzsignal (SET) anliegt.

## Claims

1. Apparatus for clock signal generation for a pipeline circuit (PS) having dynamic registers in the form of dynamic master and slave latches which are connected upstream of logic blocks (L1, L2) and in each case comprise a switch (S1) and a parasitic capacitance (C1) of the respective logic block,
- in which a clock monitoring device (TC) is provided, which determines whether or not the clock rate of an input clock signal (Φ₀) has fallen below a predetermined minimum clock rate,
- in which means (UI, GI, NOA1, NOA2) are provided which, from an input clock signal (**Φ**₀), form a master clock signal (Φₘ) and a slave clock signal (**Φ**ₛ) which are in a form such that all the switches (S1) of the dynamic master latches (ML) and all the switches (S2) of the dynamic slave latches (SL) are closed provided that the clock rate has fallen below the minimum clock rate, and otherwise at most either all the switches (S1) of the dynamic master latches (ML) or all the switches (S2) of the dynamic slave latches (SL) are closed,
- in which a first clock signal (**Φ**_{q}) and a second clock signal (**Φ**ₙ) which is the inverse of the said first clock signal are formed from the input clock signal (**Φ**₀),
- in which, in a first logic circuit (NOA1), the first clock signal is ANDed with the inverted slave clock signal (**Φ**iₛ) and subsequently NORed with a set signal (SET) to form the inverted master clock signal (**Φ**iₘ),
- in which, in a second logic circuit (NOA2), the second clock signal is ANDed with the inverted master clock signal and subsequently NORed with the set signal (SET) to form the inverted slave clock signal, and
- in which the clock monitoring device (TC) is provided in such a manner that it sets the set signal (SET) equal to logic 1 if the clock rate of the input clock signal has fallen below a minimum clock rate, and
- in which the clock monitoring device (TC) is constructed with a further first and second n-channel MOS field-effect transistor (M11, M41), a further first and second p-channel MOS field-effect transistor (M21, M51), a first capacitance (C_{q}) and a second capacitance (Cₙ) as well as an OR circuit (OR),
- the further first n-channel MOS field-effect transistor (M11) and the further first p-channel MOS field-effect transistor (M21) being connected in series via a first junction point (1) and the series circuit being connected to reference-earth potential (GND) and a supply voltage (VDD),
- the further second n-channel MOS field-effect transistor (M41) and the further second p-channel MOS field-effect transistor (M51) being connected in series via a second junction point (2) and the series circuit being connected to reference-earth potential (GND) and a supply voltage (VDD),
- the first junction point (1) being connected directly to the gate terminal of the first p-channel MOS field-effect transistor (M21), directly to a first input of the OR circuit and, via the first capacitance, to reference-earth potential (GND),
- the second junction point (2) being connected directly to the gate terminal of the second p-channel MOS field-effect transistor (M51), directly to a second input of the OR circuit and, via the second capacitance, to reference-earch potential (GND), and
- the first clock signal (**Φ**ₙ), being present at the gate terminal of the further first n-channel MOS field-effect transistor (M11), the second clock signal (**Φ**ₚ) being present at the gate terminal of the further second n-channel MOS field-effect transistor (M21), and the set signal (SET) being present at the output of the OR circuit.

2. Apparatus for clock signal generation for a pipeline circuit (PS) having dynamic registers in the form of dynamic master and slave latches which are connected upstream of logic blocks (L1, L2) and in each case comprise a switch (S1) and a parasitic capacitance (C1) of the respective logic block,
- in which a clock monitoring device (TC) is provided, which determines whether or not the clock rate of an input clock signal (**Φ**₀) has fallen below a predetermined minimum clock rate,
- in which means (UI, GI, NOA1, NOA2) are provided which, from an input clock signal (Φ₀), form a master clock signal (Φₘ) and a slave clock signal (Φₛ) which are in a form such that all the switches (S1) of the dynamic master latches (ML) and all the switches (S2) of the dynamic slave latches (SL) are closed provided that the clock rate has fallen below the minimum clock rate, and otherwise at most either all the switches (S1) of the dynamic master latches (ML) or all the switches (S2) of the dynamic slave latches (SL) are closed,
- in which a first clock signal (**Φ**_{q}) and a second clock signal (**Φ**ₙ) which is the inverse of the said first clock signal are formed from the input clock signal (Φ₀),
- in which, in a first logic circuit (NOA1), the first clock signal is ANDed with the inverted slave clock signal (**Φ**iₛ) and subsequently NORed with a set signal (SET) to form the inverted master clock signal (Φiₘ),
- in which, in a second logic circuit (NOA2), the second clock signal is ANDed with the inverted master clock signal and subsequently NORed with the set signal (SET) to form the inverted slave clock signal, and
- in which the clock monitoring device (TC) is provided in such a manner that it sets the set signal (SET) equal to logic 1 if the clock rate of the input clock signal has fallen below a minimum clock rate, and
- in which the clock monitoring device (TC) has a ring oscillator (ROSC), a first counter/decoder unit (CD1), a second counter/decoder unit (CD2) and a flip-flop (FF),
- a counter input (inl) of the first counter/decoding unit (CD1) being connected to an output of the ring oscillator (ROSC), a reset input (resetl) of the first counter/decoding unit being connected to a line for the first clock signal (Φₙ), and an output (out1) of the first counter/decoding unit being connected to a set input (S) of the RS flip-flop,
- the ratio of the clock rate of the ring oscillator (ROSC) to the minimum clock rate of the input clock signal being defined in the first counter/decoding unit,
- a counter input (in2) of the second counter/decoding unit (CD2) being connected to the line for the first clock signal (Φₙ), a reset input (reset2) of the second counter/decoding unit being connected to the output (out1) of the first counter/decoding unit, and an output (out2) of the second counter/decoding unit being connected to a reset input (R) of the RS flip-flop,
- the number of clock pulses, at a clock rate which is greater than or equal to the minimum clock rate of the input clock signal, that are counted before the flip-flop(FF) is reset being defined in the second counter/decoding unit, and
- the set signal (SET) being present at the output of the flip-flop (FF).

## Revendications

1. Dispositif de production d'impulsions d'horloge pour un circuit (PS) pipeline à registres dynamiques sous la forme de loquets maîtres et esclaves dynamiques qui sont montés en amont de blocs (L1, L2) logiques et qui sont constitués chacun d'un interrupteur (S1) et d'une capacité (C1) parasitaire du bloc logique associé,
- dans lequel il est prévu un dispositif (TC) de surveillance d'horloge qui détermine si l'on est ou non au-dessous d'une fréquence d'horloge minimale prescrite d'un signal (Φ₀) d'horloge d'entrée,
- dans lequel sont prévus des moyens (UI, GI, NOA1, NOA2) qui forment à partir d'un signal (Φ₀) d'horloge d'entrée un signal (Φₘ) d'horloge maître et un signal (Φₛ) d'horloge esclave qui sont tels que tant tous les interrupteurs (S1) du loquet (ML) maître dynamique que tous les interrupteurs (S2) du loquet (SL) esclave dynamique sont fermés dans la mesure où l'on est au-dessous de la fréquence d'horloge minimale, et sinon au plus tous les interrupteurs (S1) du loquet (ML) maître dynamique ou tous les interrupteurs (S2) du loquet (SL) esclave dynamique sont fermés,
- dans lequel un premier signal (Φ_{q}) d'horloge et un deuxième signal (Φₙ) d'horloge inverse par rapport au premier sont formés à partir du signal (Φ₀) d'horloge d'entrée,
- dans lequel, dans un premier circuit (NOA1) logique, le premier signal d'horloge est combiné ET au signal (Φiₛ) d'horloge esclave inversé et est ensuite combiné NON-OU à un signal (SET) de positionnement par rapport au signal (Φiₘ) d'horloge maître inversé,
- dans lequel, dans un deuxième circuit (NOA2) logique, le deuxième signal d'horloge est combiné ET au signal d'horloge maître inversé et est ensuite combiné NON-OU au signal (SET) de positionnement par rapport au signal d'horloge esclave et
- dans lequel le dispositif (TC) de surveillance d'horloge est prévu de manière à rendre égal le signal (SET) de positionnement à un un logique si l'on est au-dessous d'une fréquence d'horloge minimale du signal d'horloge d'entrée, et
- dans lequel le dispositif (TC) de surveillance d'horloge est constitué d'un premier et d'un deuxième transistor (M11, M41) à effet de champ MOS à canal de type de conductivité n supplémentaire, d'un premier et d'un deuxième transistor (M21, M51) à effet de champ MOS à canal de conductivité p supplémentaire, d'une première capacité (C_{q}) et d'une deuxième capacité (Cₙ) ainsi que d'un circuit (OR) OU,
- le premier transistor (M11) à effet de champ MOS à canal de type de conductivité n supplémentaire et le premier transistor (M21) à effet de champ MOS à canal de type de conductivité p supplémentaire étant montés en série par l'intermédiaire d'un premier point (1) de liaison et le circuit série étant relié au potentiel (GND) de référence et à une tension (VDD) d'alimentation,
- le deuxième transistor (M41) à effet de champ MOS à canal de type de conductivité n supplémentaire et le deuxième transistor (M51) à effet de champ MOS à canal de conductivité p supplémentaire était montés en série par l'intermédiaire d'un deuxième point (2) de liaison et le circuit série étant relié au potentiel (GND) de référence et à une tension (VDD) d'alimentation,
- le premier point (1) de liaison étant relié directement à la borne de grille du premier transistor (M21) à effet de champ MOS à canal de type de conductivité p, directement à une première entrée du circuit OU et, par l'intermédiaire de la première capacité, au potentiel (GND) de référence,
- le deuxième point (2) de liaison étant relié directement à la borne de grille du deuxième transistor (M51) à effet de champ MOS à canal de type de conductivité p, directement à une deuxième entrée du circuit OU et, par l'intermédiaire de la deuxième capacité, au potentiel (GND) de référence et
- le premier signal (Φₙ) d'horloge s'appliquant à la borne de grille du premier transistor (M11) à effet de champ MOS à canal de type de conductivité n supplémentaire, le deuxième signal (Φₚ) d'horloge s'appliquant à la borne de grille du deuxième transistor (M21) à effet de champ MOS à canal de type de conductivité n supplémentaire et le signal (SET) de positionnement s'appliquant à la sortie du circuit OU.

2. Dispositif de production d'impulsions d'horloge pour un circuit (PS) pipeline à un registre dynamique sous la forme de loquets maîtres et esclaves dynamiques qui sont montés en amont de blocs (L1, L2) logiques et qui sont constitués chacun d'un interrupteur (S1) et d'une capacité (C1) parasitaire du bloc logique associé,
- dans lequel il est prévu un dispositif (TC) de surveillance d'horloge qui détermine si l'on est ou non au-dessous d'une fréquence d'horloge minimale prescrite d'un signal (Φ₀) d'horloge d'entrée,
- dans lequel sont prévus des moyens (Ul, GI, NOA1, NOA2) qui forment à partir d'un signal (Φ₀) d'horloge d'entrée un signal (Φₘ) d'horloge maître et un signal (Φₛ) d'horloge esclave qui sont tels que tant tous les interrupteurs (S1) du loquet (ML) maître dynamique que tous les interrupteurs (S2) du loquet (SL) esclave dynamique sont fermés dans la mesure où l'on est au-dessous de la fréquence d'horloge minimale, et si non au plus tous les interrupteurs (S1) du loquet (ML) maître dynamique ou tous les interrupteurs (S2) du loquet (SL) esclave dynamique sont fermés,
- dans lequel un premier signal (Φ_{q}) d'horloge et un deuxième signal (Φₙ) d'horloge inverse par rapport au premier sont formés à partir du signal (Φ₀) d'horloge d'entrée,
- dans lequel, dans un premier circuit (NOA1) logique, le premier signal d'horloge est combiné ET au signal (Φiₛ) d'horloge esclave inversé et est ensuite combiné NON-OU à un signal (SET) de positionnement par rapport au signal (Φiₘ) d'horloge maître inversé,
- dans lequel, dans un deuxième circuit (NOA2) logique, le deuxième signal d'horloge est combiné ET au signal d'horloge maître inversé et est ensuite combiné NON-OU au signal (SET) de positionnement par rapport au signal d'horloge esclave et
- dans lequel le dispositif (TC) de surveillance d'horloge est prévu de manière à rendre égal le signal (SET) de positionnement à un un logique si l'on est au-dessous d'une fréquence d'horloge minimale du signal d'horloge d'entrée, et
- dans lequel le dispositif (TC) de surveillance d'horloge comporte un oscillateur (ROSC) annulaire, une première unité (CD1) de compteur/décodeur, une deuxième unité (CD2) de compteur/décodeur et une bascule (FF),
- une entrée (in1) de compteur de la première unité (CD1) de compteur/décodeur étant reliée à une sortie de l'oscillateur (ROSC) annulaire, une entrée (reset1) de remise à l'état initial de la première unité de compteur/décodeur étant reliée à une ligne pour le premier signal (Φₙ) d'horloge et une sortie (out1) de la première unité de compteur/décodeur étant reliée à une entrée (S) de positionnement de la bascule RS,
- le rapport de la fréquence d'horloge de l'oscillateur (ROSC) annulaire à la fréquence d'horloge minimale du signal d'horloge d'entrée étant fixé dans la première unité de compteur/décodeur,
- une entrée (in2) de compteur de la deuxième unité (CD2) de compteur/décodeur étant reliée à la ligne pour le premier signal (Φₙ) d'horloge, une entrée (reset2) de remise à l'état initial de la deuxième unité de compteur/décodeur étant reliée à la sortie (out1) de la première unité de compteur/décodeur et une sortie (out2) de la deuxième unité de compteur/décodeur étant reliée à une entrée (R) de remise à l'état initial de la bascule (RS),
- il est fixé dans la deuxième unité de compteur/décodeur le nombre d'impulsions d'horloge pour une fréquence d'horloge, qui est supérieure ou égale à la fréquence d'horloge minimale du signal d'horloge d'entrée, avant que la bascule (FS) ne soit remise à l'état initial, et
- le signal (SET) de positionnement s'applique à la sortie de la bascule (FS).
